# EUROPÄISCHE PATENTSCHRIFT

(11) **EP 2 113 967 B1**
(45) Veröffentlichungstag und Bekanntmachung des Hinweises auf die Patenterteilung: **24.02.2016**
(21) Anmeldenummer: 09153486.7
(22) Anmeldetag: 24.02.2009
(51) Int. Cl.: H05K 1/14

(54) **Anordnung zweier Schaltungsträger**
Assembly of two circuit boards
Agencement de deux circuits imprimés

(30) Priorität: 29.04.2008 AT 6612008
(43) Veröffentlichungstag der Anmeldung: 04.11.2009
(73) Patentinhaber: Siemens Aktiengesellschaft, 80333 München (DE)
(72) Erfinder: Ecker, Martin Ernst, 3542 Jaidhof (AT); Neuffer, Wolfgang, 1220 Wien (AT)
(74) Vertreter: Maier, Daniel Oliver

(56) Entgegenhaltungen:
- EP-A2- 1 643 596
- US-A- 3 820 061
- US-A- 5 624 269
- US-A- 5 715 595
- US-A- 6 155 887
- US-A1- 2006 166 526

## Beschreibung

Die Erfindung betrifft eine Anordnung von zwei in einem festen Abstand voneinander gehaltenen Schaltungsträgern, wobei ein elektrischer Kontakt des ersten Schaltungsträgers mit einem elektrischen Kontakt des zweiten Schaltungsträgers elektrisch leitend verbunden ist.

In vielen elektrischen und elektronischen Geräten, insbesondere Schaltnetzteilen, besteht die Notwendigkeit, Schaltungen auf mehrere Schaltungsträger aufzuteilen, wobei diese Schaltungsträger über geeignete Kontaktelemente miteinander elektrisch leitend verbunden sind. Häufig sind Schaltungsträger orthogonal oder parallel zueinander innerhalb eines Gehäuses angeordnet.

US 3 820 061 A offenbart eine Steckzunge zum Verbinden von elektrischen Kontakten auf zwei Schaltungsträgern. Die Enden der Steckzunge werden jeweils durch die respektiven Löcher der Kontakte auf den zwei Schaltungsträgern geführt und damit elektrisch verbunden.

Die Fixierung von zwei in festen Abstand voneinander gehaltenen Schaltungsträgern erfolgt entweder über geeignete Verbindungsmittel mit dem Gehäuse oder durch entsprechende Haltevorrichtungen zwischen den Schaltungsträgern. Dabei ist meist eine Mindeststabilität der Schaltungsträgerbefestigungen gefordert, welche beispielsweise mittels Rütteltests geprüft wird.

Übliche Kontaktelemente zur elektrischen Verbindung verschiedener Schaltungsträger sind einpolige oder mehrpolige Verbindungskabel unter Zuhilfenahme von Steckerleisten an den Rändern der Schaltungsträger. Für hohe Dauerströme (z.B. 20A) sind derartige Verbindungen besonders teuer und können bei einem pulsierendem Strom oder einem Wechselstrom zu unerwünschten Störemissionen führen.

Kurze elektrische Verbindungen zwischen zwei Schaltungsträgern mit geringer Störemission werden in der Regel mittels im Handel erhältlicher Verbindungsstifte (z.B. Stifte der Firma SAMTEC) ausgeführt. Dabei ist ein Stiftende mit einem elektrischen Kontakt eines ersten Schaltungsträgers und das andere Stiftende mit einem elektrischen Kontakt eines zweiten Schaltungsträgers verbunden. Derartige Stifte sind allerdings nur zur Übertragung von Dauerströmen bis ca. 4A geeignet. Zudem ist aufgrund der mangelnden mechanischen Belastbarkeit meist eine zusätzliche Halterung notwendig, um die Schaltungsträger in einem festen Abstand zueinander zu halten.

Aus der AT 500 260 A1 kennt man auch eine als Stift ausgeführte Kontaktbrücke, die an einem ersten Kontaktende eine Kontaktplatte trägt, welche mit einer Anschlussfläche auf dem ersten Schaltungsträger verlötet ist. Mit einem zweiten Kontaktende durchsetzt die Kontaktbrücke den zweiten Schaltungsträger und ist dabei mit einer Leiterbahn dieses zweiten Schaltungsträgers kontaktiert. Eine derartige Verbindung eignet sich zwar für hohe Ströme über 4A, allerdings muss die Kontaktbrücke eigens hergestellt werden.

Der Erfindung liegt die Aufgabe zugrunde, für eine Anordnung der eingangs genannten Art eine Verbesserung gegenüber dem Stand der Technik anzugeben.

Erfindungsgemäß wird diese Aufgabe gelöst durch eine Anordnung von zwei in einem festen Abstand voneinander gehaltenen Schaltungsträgern, wobei ein elektrischer Kontakt des ersten Schaltungsträgers mit einem elektrischen Kontakt des zweiten Schaltungsträgers elektrisch leitend verbunden ist. Dabei ist der elektrische Kontakt des ersten Schaltungsträgers als wenigstens eine durchkontaktierte oder einseitig kaschierte Bohrung ausgebildet, in welche wenigstens eine Anschlussfahne einer Steckzunge eingelötet oder eingepresst ist, wobei der elektrische Kontakt des zweiten Schaltungsträgers als durchkontaktiertes oder einseitig kaschiertes Langloch ausgebildet ist, durch das ein Abschnitt der Steckzunge geführt ist. Die Steckzunge weist eine zweite Anschlussfahne auf, welche in eine zweite Bohrung im ersten Schaltungsträger eingelötet oder eingepresst ist und die beiden Bohrungen bilden im ersten Schaltungsträger verschiedene elektrische Kontakte, welche jeweils mit verschiedenen Leiterbahnen oder direkt mit verschiedenen Anschlüssen von Schaltungselementen verbunden sind, sodass diese Leiterbahnen oder Anschlüsse über die Steckzunge elektrisch verbunden sind.

Steckzungen sind in verschiedenen Formen im Handel erhältlich und werden nach dem Stand der Technik gemeinsam mit Steckhülsen zur Ausbildung elektrischer Steckverbindungen verwendet. Die erfindungsgemäße Kontaktierung einer auf einem ersten Schaltungsträger angeordneten Steckzunge mit einem Langloch in einem zweiten Schaltungsträger führt zu einer mechanisch stabilen Verbindung zwischen den beiden Schaltungsträgern, welche für hohe Dauerströme (z.B. ca. 20A) geeignet ist.

Dabei ist es von Vorteil, wenn die Langlochbreite ungefähr der Dicke des durch das Langloch geführten Abschnitts der Steckzunge entspricht und/oder wenn die Langlochlänge ungefähr der Breite des durch das Langloch geführten Abschnitts der Steckzunge entspricht. Die Steckzunge wird auf diese Weise während der Montage im an den Querschnitt der Steckzunge angepassten Langloch in Position gehalten. Zum einfachen Einführen der Steckzunge in das Langloch ist eine üblicherweise am Ende der Steckzunge vorgesehene Fase hilfreich.

In einer Ausprägung bilden das Langloch im zweiten Schaltungsträger und der durch dieses Langloch geführte Abschnitt der Steckzunge eine Spielpassung. Die Steckzunge ist dann während der Montage ohne Kraftaufwand in das Langloch einführbar.

Eine weitere Verbesserung sieht vor, dass der durch das Langloch geführte Abschnitt der Steckzunge eine lötbare Oberfläche aufweist und in das Langloch im zweiten Schaltungsträger eingelötet ist. Dadurch wird die mechanische Stabilität weiter erhöht und die Kontaktierung zwischen der Steckzunge und dem zweiten Kontakt des zweiten Schaltungsträgers verbessert.

Zudem ist es vorteilhaft, wenn der durch das Langloch geführte Abschnitt der Steckzunge über den Rand des Langlochs hinausragt. Der herausragende Teil bildet dann eine zusätzliche Lötkontaktfläche, insbesondere zum Verlöten mit einem einseitig kaschierten Langloch.

Eine andere einfache Ausprägung der Erfindung sieht vor, dass die Steckzunge in das Langloch eingepresst ist. Eine Presspassung zwischen Steckzunge und Langloch schafft auch ohne nachträgliches Verlöten einen stabilen Kontakt, der auf einfache Weise wieder gelöst werden kann.

Die Erfindung wird nachfolgend in beispielhafter Weise unter Bezugnahme auf die beigefügte Figur erläutert. Es zeigt in schematischer Darstellung:

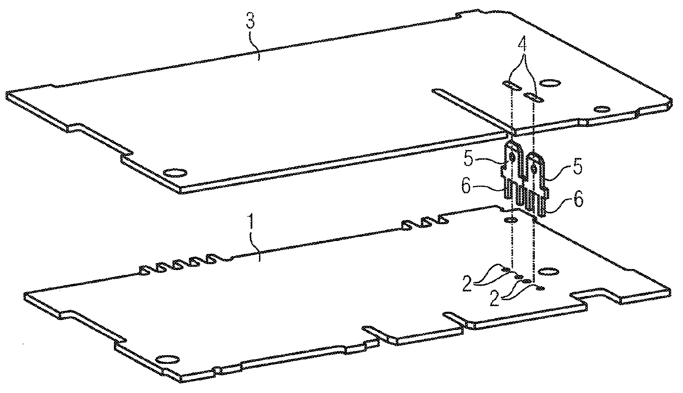

- Fig. 1: Explosionsdarstellung der Anordnung

Die in Fig. 1 dargestellte Anordnung betrifft eine elektronische Schaltung, deren Schaltungselemente auf zwei in einem festen Abstand voneinander gehaltenen Schaltungsträgern 1, 3 angeordnet sind. Der Übersichtlichkeit halber sind die Schaltungsträger 1, 3 ohne diese Schaltungselemente und Leiterbahnen gezeichnet.

Die beispielhafte Anordnung umfasst zwei elektrisch leitende Verbindungen zwischen den beiden Schaltungsträgern 1, 3. Dabei sind zwei elektrische Kontakte des ersten Schaltungsträgers 1 mit zwei elektrischen Kontakten des zweiten Schaltungsträgers 3 mittels jeweils einer Steckzunge 5 verbunden. Die elektrischen Kontakte der Schaltungsträger 1, 3 sind beispielsweise mit Leiterbahnen oder direkt mit Anschlüssen von Schaltungselementen verbunden.

Die dargestellten Steckzungen 5 umfassen jeweils zwei Anschlussfahnen 6, welche in als durchkontaktierte Bohrungen 2 ausgeführte elektrische Kontakte des ersten Schaltungsträgers 1 eingepresst oder eingelötet sind. Anstelle dieser Steckzungenart können auch anders geformte Steckzungen verwendet werden, insbesondere solche mit nur einer Anschlussfahne 6, welche nur eine durchkontaktierte Bohrung 2 im ersten Schaltungsträgers 1 erfordern. Alternativ dazu kann die Bohrung 2 bzw. können die Bohrungen 2 einseitig kaschiert ausgeführt und mit herausragenden Enden der Anschlussfahnen 6 verlötet sein.

Die Montage der Steckzungen 5 erfolgt zum Beispiel in der Weise, dass die Steckzungen 5 mittels automatischer Bestückung am ersten Schaltungsträger 1 platziert werden und dass im Anschluss daran die Anschlussfahnen 6 mittels Schwalllöten fixiert werden.

Nachdem der erste Schaltungsträger 1 mit den Steckzungen 5 bestückt wurde, erfolgt die Positionierung des zweiten Schaltungsträgers 3. Dabei werden die Endabschnitte der Steckzungen 5 durch als durchkontaktierte Langlöcher 4 ausgeführte Kontakte des zweiten Schaltungsträger 3 geführt.

Die an den Endabschnitten angebrachten Fasen erleichtern diesen Monatageschritt.

Alternativ zur Durchkontaktierung der Langlöcher 4 können diese auch einseitig kaschiert ausgeführt sein. In diesem Fall ist die jeweilige Steckzunge 5 mit der den Langlochrand umgebenden Lötfläche verlötet.

Falls die Langlöcher 4 und die Endabschnitte der Steckzungen 5 eine Presspassung bilden, hängt die Notwendigkeit eines zusätzlichen Einlötens von der geforderten Rüttelbelastbarkeit der Anordnung ab.

Um einen dauerhaft sicheren Halt bei erhöhter Beanspruchung sicherzustellen, werden die Endabschnitte der Steckzungen 5 in die Langlöcher 4 des zweiten Schaltungsträgers 3 eingelötet. Die dabei entstehende mechanische Verbindung der beiden Schaltungsträger 1, 3 ist in der Regel ausreichend stabil, sodass zusätzliche Befestigungseinrichtungen zur festen Beabstandung der beiden Schaltungsträger 1, 3 entfallen können. Das gilt insbesondere dann, wenn eine Anordnung mehrere Steckzungen 5 umfasst, wobei die Anschlussfahnen 6 in die Bohrungen 2 und die Endabschnitte der Steckzungen 5 in die Langlöcher 4 eingelötet sind.

## Patentansprüche

1. Anordnung von zwei in einem festen Abstand voneinander gehaltenen Schaltungsträgern (1, 3), wobei ein elektrischer Kontakt des ersten Schaltungsträgers (1) mit einem elektrischen Kontakt des zweiten Schaltungsträgers (3) elektrisch leitend verbunden ist, wobei der erste elektrische Kontakt des ersten Schaltungsträgers (1) eine durchkontaktierte oder einseitig kaschierte Bohrung (2) umfasst, in welche eine Anschlussfahne (6) einer Steckzunge (5) eingelötet oder eingepresst ist und wobei der elektrische Kontakt des zweiten Schaltungsträgers (3) als durchkontaktiertes oder einseitig kaschiertes Langloch (4) ausgebildet ist, durch das ein Abschnitt der Steckzunge (5) geführt ist, wobei die Steckzunge (5) eine zweite Anschlussfahne (6) aufweist, welche in eine zweite Bohrung (2) im ersten Schaltungsträger (1) eingelötet oder eingepresst ist und dass die beiden Bohrungen (2) im ersten Schaltungsträger (1) verschiedene elektrische Kontakte bilden, welche jeweils mit verschiedenen Leiterbahnen oder direkt mit verschiedenen Anschlüssen von Schaltungselementen verbunden sind, sodass diese Leiterbahnen oder Anschlüsse über die Steckzunge (5) elektrisch verbunden sind.

2. Anordnung nach Anspruch 1, **dadurch gekennzeichnet, dass** die Langlochbreite ungefähr der Dicke des durch das Langloch (4) geführten Abschnitts der Steckzunge (5) entspricht.

3. Anordnung nach Anspruch 1 oder 2, **dadurch gekennzeichnet, dass** die Langlochlänge ungefähr der Breite des durch das Langloch (4) geführten Abschnitts der Steckzunge (5) entspricht.

4. Anordnung nach einem der Ansprüche 1 bis 3, **dadurch gekennzeichnet, dass** das Langloch (4) im zweiten Schaltungsträger (3) und der durch dieses Langloch (4) geführte Abschnitt der Steckzunge (5) eine Spielpassung bilden.

5. Anordnung nach einem der Ansprüche 1 bis 4, **dadurch gekennzeichnet, dass** der durch das Langloch (4) geführte Abschnitt der Steckzunge (5) eine lötbare Oberfläche aufweist und in das Langloch (4) im zweiten Schaltungsträger (3) eingelötet ist.

6. Anordnung nach einem der Ansprüche 1 bis 5, **dadurch gekennzeichnet, dass** der durch das Langloch (4) geführte Abschnitt der Steckzunge (5) über den Rand des Langlochs (4) hinausragt.

7. Anordnung nach Anspruch 2 oder 3, **dadurch gekennzeichnet, dass** die Steckzunge (5) in das Langloch (6) eingepresst ist.

## Claims

1. Arrangement of two circuit substrates (1, 3) held at a fixed distance from one another, wherein an electrical contact of the first circuit substrate (1) is connected to an electrical contact of the second circuit substrate (3) in an electrically conductive manner, wherein the first electrical contact of the first circuit substrate (1) comprises a hole (2) which is plated-through or only printed on one side, into which a connecting lug (6) of a plug-in tongue (5) is soldered or pressed and wherein the electrical contact of the second circuit substrate (3) is embodied as a slot (4) which is plated-through or only printed on one side, through which a section of the plug-in tongue (5) is guided, wherein the plug-in tongue (5) has a second connecting lug (6) which is soldered or pressed into a second hole (2) in the first circuit substrate (1) and the two holes (2) in the first circuit substrate (1) form different electrical contacts which are each connected to different conductor paths or directly to different connectors of circuit elements, so that said conductor paths or connectors are electrically connected via the plug-in tongue (5).

2. Arrangement according to claim 1, **characterised in that** the slot width approximately correlates with the thickness of the section of the plug-in tongue (5) guided through the slot (4).

3. Arrangement according to claim 1 or 2, **characterised in that** the slot length approximately correlates with the width of the section of the plug-in tongue (5) guided through the slot (4).

4. Arrangement according to one of claims 1 to 3, **characterised in that** the slot (4) in the second circuit substrate (3) and the section of the plug-in tongue (5) guided through said slot (4) form a clearance fit.

5. Arrangement according to one of claims 1 to 4, **characterised in that** the section of the plug-in tongue (5) guided through the slot (4) has a solderable surface and is soldered into the slot (4) in the second circuit substrate (3).

6. Arrangement according to one of claims 1 to 5, **characterised in that** the section of the plug-in tongue (5) guided through the slot (4) projects beyond the edge of the slot (4).

7. Arrangement according to claim 2 or 3, **characterised in that** the plug-in tongue (5) is pressed into the slot (6).

## Revendications

1. Agencement de deux supports de circuit (1, 3) maintenus à une distance fixe l'un de l'autre, un contact électrique du premier support de circuit (1) étant relié de manière électriquement conductrice à un contact électrique du deuxième support de circuit (3), le premier contact électrique du premier support de circuit (1) comprenant un perçage (2) métallisé ou recouvert d'un côté, dans lequel est soudée ou insérée à force une patte de connexion (6) d'une languette (5), et le contact électrique du deuxième support de circuit (3) étant réalisé sous forme de trou oblong (4) métallisé ou recouvert d'un côté, dans lequel passe une partie de la languette (5), laquelle languette (5) présentant une deuxième patte de connexion (6) qui est soudée ou insérée à force dans un deuxième perçage (2) réalisé dans le premier support de circuit (1), et les deux perçages (2) réalisés dans le premier support de circuit (1) formant différents contacts électriques, reliés chacun à différentes pistes conductrices ou directement à différentes bornes d'éléments de circuit, de sorte que ces pistes conductrices ou bornes sont reliées électriquement par l'intermédiaire de la languette (5).

2. Agencement selon la revendication 1, **caractérisé en ce que** la largeur du trou oblong correspond approximativement à l'épaisseur de la partie de la languette (5) passant dans le trou oblong (4).

3. Agencement selon la revendication 1 ou 2, **caractérisé en ce que** la longueur du trou oblong correspond approximativement à la largeur de la partie de la languette (5) passant dans le trou oblong (4).

4. Agencement selon l'une des revendications 1 à 3, **caractérisé en ce que** le trou oblong (4) dans le deuxième support de circuit (3) et la partie de la languette (5) passant dans ce trou oblong (4) forment un ajustement avec jeu.

5. Agencement selon l'une des revendications 1 à 4, **caractérisé en ce que** la partie de la languette (5) passant dans le trou oblong (4) présente une surface soudable et est soudée dans le trou oblong (4) dans le deuxième support de circuit (3).

6. Agencement selon l'une des revendications 1 à 5, **caractérisé en ce que** la partie de la languette (5) passant dans le trou oblong (4) dépasse le bord du trou oblong (4).

7. Agencement selon la revendication 2 ou 3, **caractérisé en ce que** la languette (5) est insérée à force dans le trou oblong (6).
